# EUROPÄISCHE PATENTANMELDUNG

(11) **EP 0 845 809 A2**
(43) Veröffentlichungstag der Anmeldung: **03.06.1998**
(21) Anmeldenummer: 97810842.1
(22) Anmeldetag: 10.11.1997
(51) Int. Cl.: H01L 25/065, H01L 23/24

(54) **Leistungshalbleitermodul**

(30) Priorität: 02.12.1996 DE 19649798
(71) Anmelder: ABB RESEARCH LTD., 8050 Zürich (CH)
(72) Erfinder: Stuck, Alexander, Dr., 5430 Wettingen (CH)
(74) Vertreter: Weibel, Beat

(57) **Zusammenfassung**

Es wird ein Leistungshalbleitermodul angegeben, bei dem im Gehäuse unter dem Gehäusedeckel eine Lage Schaumstoff angeordnet ist. Der Schaumstoff ermöglicht nicht nur eine mechanische Stützung der Vergussmasse, so dass eine Ablösung derselben verhindert wird, sondern kann auch einen grossen Druckanstieg im Falle eines Kurzschlusses durch Komprimierung aufnehmen. Auf diese Weise wird ein Ausgleichsvolumen geschaffen, ohne dass das Gehäuse zerstört wird. Das Gehäuse bleibt geschlossen und es wird kein Material in die Umgebung geschleudert.

## Beschreibung

### Technisches Gebiet

Die Erfindung bezieht sich auf das Gebiet der Leistungshalbleiterelektronik. Sie geht aus von einem Leistungshalbleitermodul gemäss dem Oberbegriff des ersten Anspruchs.

### Stand der Technik

Ein solches Leistungshalbleitermodul wird bereits in der Europäischen Patentanmeldung EP 0 597 144 A1 beschrieben. Gattungsgemässe Leistungshalbleitermodule umfassen ein Gehäuse, in welchem auf einer Bodenplatte, die gleichzeitig auch noch Kühlzwecken dienen kann, mindestens ein Halbleiterchip angeordnet sind. Die Halbleiterchips werden mit nach aussen geführten Anschlüssen und bei mehreren Chips untereinander mittels Kontaktbahnen elektrisch verbunden. Der Hohlraum zwischen Gehäusedeckel und Bodenplatte kann mit einer Vergussmasse, z.B. einem isolierenden Gel, aufgefüllt sein. Bei einem freien Gasvolumen in dem Gehäuse besteht längerfristig die Gefahr, dass sich das Gel unter seinem Eigengewicht von der Oberfläche der elektronischen Komponenten löst und somit die Hochspannungsisolation nicht mehr gewährleisten kann.

Diese Module können Teil einer Stromrichterschaltungsanordnung sein. Tritt nun in einer solchen Schaltungsanordnung ein Kurzschluss auf, so kann dieser Teile der Schaltungsanordnung zerstören. Ein Kurzschluss in einem Modul kann leicht zu einer Explosion des Moduls führen, wenn nicht geeignete Gegenmassnahmen getroffen werden.

Im Artikel "Reliable 1200 Amp 2500 V IGBT Modules for Traction Applications", IEE IGBT Propulsion Drives Colloquium, London, 25. April 1995 wird deshalb vorgeschlagen, das Gehäuse mit Sollbruchstellen zu versehen, die den maximalen Druck im Modul begrenzen. An diesen Sollbruchstellen bricht das Gehäuse im Fall einer Explosion auf und Gel oder Bestandteile des Moduls können durch die gebildete Öffnung austreten. Herumfliegende Gehäuseteile oder herausgeschleudertes Gel stellen aber eine unerwünschte Gefahrenquelle dar. Herumgespritztes Material verschmutzt die Umgebung und kann zu einem Totalausfall des Gerätes führen.

### Darstellung der Erfindung

Aufgabe der vorliegenden Erfindung ist es deshalb, ein Modul anzugeben, das eine problemlose Langzeitisolation ermöglicht und möglichst explosionsunempfindlich ist. Diese Aufgabe wird bei einem Leistungshalbleitermodul der eingangs genannten Art durch die Merkmale des ersten Anspruchs gelöst.

Kern der Erfindung ist es also, dass im Gehäuse unter dem Gehäusedeckel eine Lage Schaumstoff angeordnet ist. Schaumstoff ermöglicht nicht nur eine mechanische Stützung des Gels, so dass eine Ablösung desselben verhindert wird, sondern er kann auch einen grossen Druckanstieg im Falle eines Kurzschlusses durch Komprimierung aufnehmen. Auf diese Weise wird ein Ausgleichsvolumen geschaffen, ohne dass das Gehäuse zerstört wird. Das Gehäuse bleibt geschlossen und es wird kein Material in die Umgebung geschleudert.

Der Schaumstoff kann in Kombination mit einer Vergussmasse verwendet werden oder aber auch bei Füllung mit einem isolierenden Gas (z. SF6) das Isolationsgel vollständig ersetzen. Besonders günstige Eigenschaften erhält man dadurch, dass dem Füllgas flammhemmende Stoffe, z.B. Borverbindungen beigemischt werden.

Weitere Ausführungsbeispiele ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
**Fig. 1** Ein erstes Ausführungsbeispiel der Erfindung im Schnitt;
**Fig. 2** Ein zweites Ausführungsbeispiel der Erfindung im Schnitt.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

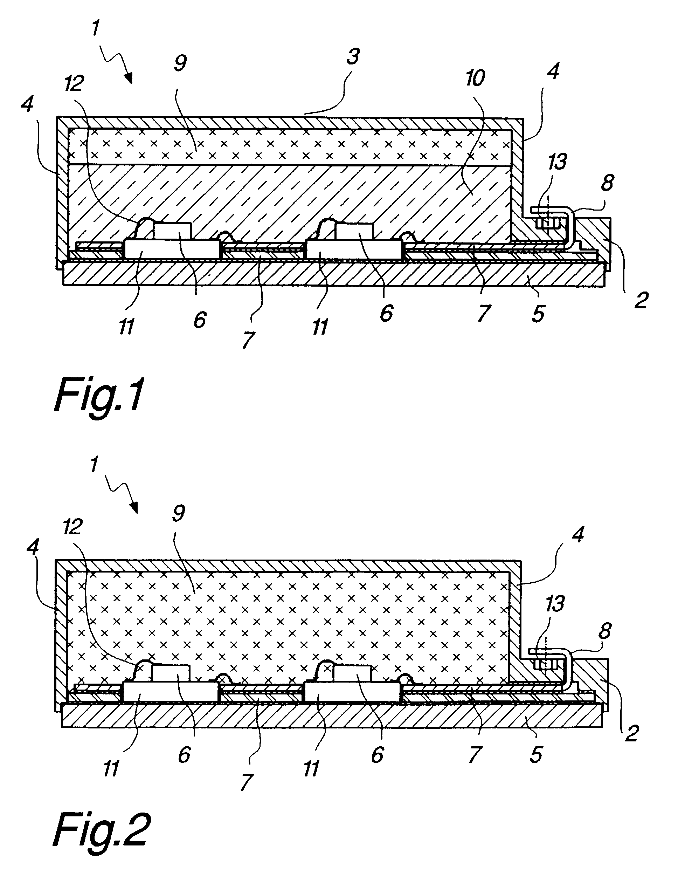

**Figur 1** zeigt ein erstes Ausführungsbeispiel der Erfindung im Schnitt. Das Leistungshalbleitermodul 1 umfasst ein Gehäuse 2. Auf einer Bodenplatte 5 sind Halbleiterchips 6 angeordnet. Zwischen den Halbleiterchips 6 und der Bodenplatte 5, die auch als Kühler dienen kann, kann ein Substrat 11, z.B. aus einer lötbaren Keramik, eingefügt sein. Es sind ausserdem Kontaktbahnen 7 vorgesehen, die den elektrischen Kontakt zwischen den Halbleiterchips 6 einerseits untereinander und andererseits mit nach aussen geführten Anschlüssen 8 herstellen. Im gezeigten Ausführungsbeispiel sind die Kontaktbahnen 7 übereinander angeordnet. Die elektrische Verbindung zwischen den Anschlüssen der Chips 6 und den Kontaktbahnen 7 kann beispielsweise mittels Bonddrähten 12 erfolgen. Weitere Kontaktierungsmöglichkeiten sind aber auch denkbar. Beim Anschluss 8 kann es sich z.B. wie dargestellt um einen Schraubanschluss mit einer Befestigungsmutter 13 handeln.

Der im wesentlichen durch Gehäusedeckel 3, Gehäusewände 4 und Bodenplatte gebildete Hohlraum ist in Richtung der Bodenplatte mit einer Vergussmasse 10, wie sie im eingangs genannten Stand der Technik erläutert wird, gefüllt. Dieser Gel hat insbesondere Isolationsaufgaben. Nach der Erfindung wird der Hohlraum gegen den Gehäusedeckel 3 hin mit einem Schaumstoff 9 aufgefüllt. Der Schaumstoff 9 kann nun so gewählt werden, dass er das Isolationsgel 10 stützt und langfristig ein Ablösen desselben verhindert. Ausserdem stellt der Schaumstoff 9 ein Ausgleichsvolumen dar, das die bei einem Kurzschluss freiwerdende Energie aufnimmt.

Das Auffüllen des Gehäuses mit Schaumstoff erlaubt es, die benötigte Menge Isolationsgel zu minimieren. Füllt man den Schaumstoff ausserdem mit einem Gas hoher Durchschlagsfestigkeit (z.B. SF₆), so ist es möglich, das Isolationsgel vollständig durch den Schaumstoff zu ersetzen. **Figur 2** zeigt ein solches Beispiel. Je nach Ausführung des Schaumstoffes bildet dieser auch einen guten Feuchtigkeitsschutz. Gegenüber dem Stand der Technik wird der Feuchtigkeitsschutz bereits schon dadurch verbessert, dass man geschäumte Gehäuse verwendet. Ausserdem kann dem Füllgas des Schaumstoffes ein flammhemmender Stoff wie z.B. Borverbindungen beigefügt werden. Dadurch wird die Feuergefahr im Kurzschlussfall stark eingedämmt. Die Schaumstoffe sind im übrigen billig und können auf einfache Art und Weise in bestehende Produktionsprozesse integriert werden.

Als Schaumstoff haben sich Silikonschäume bewährt. Silikonschäume der 800-er Serie der Firma Dow Corning sind bis 205°C temperaturbeständig und nicht brennbar. Sie sind je nach Typ sehr elastisch bis recht hart. Typisch bestehen ungefähr zwei Drittel des Schaumvolumens aus Gas. Ersetzt man bei den Modulkonstruktionen nach dem eingangs genannten Stand der Technik den eingesetzten Hartgummi (Volumen ca. 80 cm³) durch Silikonschaum, so wirkt der Schaum bei einem Kurzschluss ähnlich wie freies Gasvolumen von ca. 50 cm³. Ersetzt man auch noch die Vergussmasse (Volumen ca. 100 cm³), so lässt sich das freie Gasvolumen bis auf ca. 120 cm³ erhöhen.

Mit der Erfindung lässt sich also ein Leistungshalbleitermodul herstellen, das eine problemlose Langzeitisolation ermöglicht und möglichst explosionsunempfindlich ist. Bei einem Kurzschluss können keine Bestandteile mehr aus dem Gehäuse geschleudert werden und allfälliges Isolationsgel wird formschlüssig festgehalten.

### Bezugszeichenliste

- 1: Leistungshalbleitermodul
- 2: Gehäuse
- 3: Gehäusedeckel
- 4: Gehäusewand
- 5: Bodenplatte
- 6: Halbleiterchip
- 7: Kontaktbahn
- 8: Anschluss
- 9: Schaumstoff
- 10: Vergussmasse
- 11: Substrat
- 12: Bonddraht
- 13: Mutter

## Patentansprüche

1. Leistungshalbleitermodul (1) umfassend ein Gehäuse (2) mit Gehäusewänden (4) und einem Gehäusedeckel (3), in welchem Gehäuse (2) eine Bodenplatte (5) mit mindestens einem darauf angeordneten Halbleiterchip (6) und Kontaktbahnen (7) angeordnet sind, welche Kontaktbahnen (7) jeden Halbleiterchip (6) mit mindestens einem aus dem Gehäuse (2) geführten Anschluss (8) und bei mehreren Halbleiterchips (6) diese untereinander elektrisch verbinden, dadurch gekennzeichnet, dass im Gehäuse (2) unter dem Gehäusedeckel (3) eine Lage Schaumstoff (9) angeordnet ist.

2. Modul nach Anspruch 1, dadurch gekennzeichnet, dass in einem Hohlraum zwischen den Gehäusewänden (4), dem Gehäusedeckel (3) und der Bodenplatte (5) eine Vergussmasse (10), insbesondere ein isolierendes Gel, vorgesehen ist, und die Lage Schaumstoff (9) zwischen der Vergussmasse (10) und dem Gehäusedeckel (3) angeordnet ist.

3. Modul nach Anspruch 1, dadurch gekennzeichnet, dass der Schaumstoff (9) einen Hohlraum zwischen den Gehäusewänden(4), dem Gehäusedeckel (3) und der Bodenplatte (8) vollständig ausfüllt.

4. Modul nach Anspruch 1, 2, oder 3, dadurch gekennzeichnet, dass der Schaumstoff (9) mit einem Füllgas hoher elektrischer Durchschlagsfestigkeit, insbesondere SF₆, gefüllt ist.

5. Modul nach Anspruch 4, dadurch gekennzeichnet, dass dem Füllgas flammhemmende Stoffe, insbesondere Borverbindungen, beigemischt sind.

6. Modul nach einem der vorstehenden Ansprüche, dadurch gekennzeichnet, dass der Schaumstoff (9) im wesentlichen aus Silikonschaum besteht.
